# EUROPEAN PATENT SPECIFICATION

(11) **EP 0 703 675 B1**
(45) Date of publication and mention of the grant of the patent: **21.11.2001**
(21) Application number: 95306783.2
(22) Date of filing: 26.09.1995
(51) Int. Cl.: H03M 7/42

(54) **Variable length decoding method and apparatus**
Verfahren und Vorrichtung zur Dekodierung mit variablen Längen
Méthode et dispositif pour le décodage à longueur variable

(30) Priority: 26.09.1994 KR 9424148
(43) Date of publication of application: 27.03.1996
(73) Proprietor: Samsung Electronics Co., Ltd., Suwon-city, Kyungki-do 441-370 (KR)
(72) Inventor: Ahn, Wooyoun, Songtan-city, Kyungki-do (KR); Cho, Myong-rae, Kangdong-gu, Seoul (KR)
(74) Representative: Chugg, David John

(56) References cited:
- EP-A- 0 589 682
- EP-A- 0 593 046
- DE-A- 4 322 995
- US-A- 4 899 149
- US-A- 5 181 031

## Description

The present invention relates to a method and apparatus for decoding variable length coded data.

In a high-definition television (HD-TV), a high-definition video cassette recorder (HD-VCR), a digital VCR, a digital camcorder or a multimedia system, both a video signal and an audio signal are digitally processed and the digitally processed signals are recorded on a recording medium, or transmitted to another reproducing apparatus. There are a prediction coding method, an orthogonal transform coding method, and a variable length coding method as proposed methods for digitally processing video information. Typical coding systems which use the above coding techniques perform an orthogonal transform coding operation, a quantization operation and a variable length coding operation with respect to blocks due to image division, in order to effectively compress video information. Such systems perform a prediction coding operation between frames or fields in order to further enhance a data compression rate.

The above-described variable length coding apparatus compresses information based on statistics of symbols. A variable length code table is stored for variable length coding input symbols. The variable length coding table is made according to a Huffman coding technique. As is well known, according to the Huffman coding technique, a shorter code is assigned to a symbol having a relatively higher frequency of occurrence and a longer code is assigned to a symbol having a relatively lower frequency of occurrence. In a typical coding system, symbols which are input to the variable length coding apparatus are [run, level] symbols which are generally obtained by a run-length coding operation. The [run, level] symbols are obtained by a well-known zig-zag scan, in which the "run" represents the number of "0s" which sequentially exist between non-zero transform coefficients obtained by the zig-zag scan, and the "level" represents a value of the non-zero transform coefficient. The variable length code table made by the Huffman coding technique is divided into an escape region for a case that even one of the "run" or "level" has a large value and a regular region for the other cases. The [run, level] symbols in the regular region are assigned with codes according to the Huffman coding technique. On the contrary, since the [run, level] symbols in the escape region are extremely low statistically in their frequency of occurrence, escape (ESC) codes for representing a [run, level] symbol in the escape region are assigned together with a longer code. Codewords generated by the variable length coding method are transmitted to a decoding system in the form of a bitstream in which additional information such as the ESC code and an end of block (EOB) representing a block end is added.

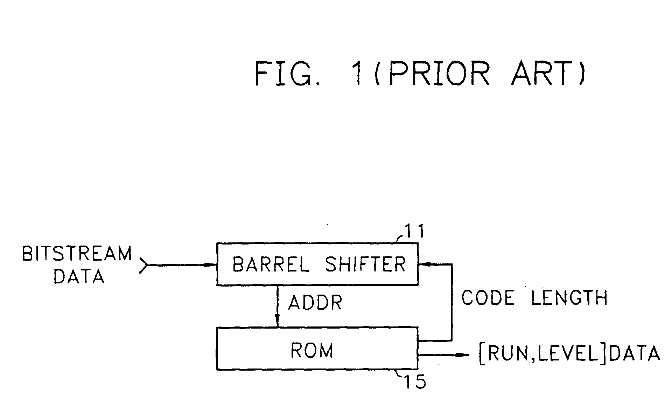

The decoding system performs a process reverse to a signal processing of the coding system, which comprises a variable length decoder, an inverse quantizer, an inverse orthogonal transformer to decode the coded information. If a bitstream is input to the conventional variable length decoder shown in Figure 1, a barrel shifter 11 outputs bit data within a window shifted by a code length received from a ROM 15 to address data ADDR of ROM 15. ROM 15 outputs the [run, level] symbols which are stored in positions designated by the address data applied from barrel shifter 11, to the inverse quantizer (not shown) which is located in the rear end. ROM 15 supplies also a length possessed by a codeword used for outputting the [run, level] symbols, that is, a code length corresponding to the variable length decoded [run, level] symbol, to barrel shifter 11. Barrel shifter 11 outputs the bit data within the window shifted by a newly applied code length to ROM 15 again. Barrel shifter 11 and ROM 15 repeat such operations and perform a variable length decoding operation continuously. Since the Figure 1 apparatus can generate a single [run, level] symbol with a single shift operation and a single reading operation (usually two clock pulse periods) irrespective of a code length, the apparatus can operate consistently and at a constant speed, and can operate at a high operation frequency.

However, the variable length decoding apparatus requires ROM 15 for storing the variable length coding table and a barrel shifter 11. Thus, when such a variable length decoding apparatus is manufactured as an application specific integrated circuit (ASIC), complexity of the hardware increases and the cost rises due to the size increase.

European Patent Application published under number 0589682 describes a decoder for decoding a Huffman code into data, comprising a barrel shifter, first and second decoder circuits each for receiving an output from the barrel shifter, a selector circuit for selectively outputting one of the decoded outputs from the decoder circuits, a shift controller for shifting the barrel shifter when signalled to do so by the first or second decoder output, and a controller for controlling the selector circuit so as to selectively output the decoded output of the first or second decoder to a data output terminal.

Therefore, with a view to solving or alleviating the above problems, it is an aim of preferred embodiments of the present invention to provide a method for performing a variable length decoding operation on the basis of similarity of data possessed by variable length codes constituting a variable length code table proposed by the Moving Picture Experts Group (MPEG) II.

Another aim of the preferred embodiments is to provide an apparatus for performing a variable length decoding operation at a processing speed required in the variable length decoding operation with simple hardware on the basis of similarity of data possessed by variable length codes constituting a variable length code table proposed by the Moving Picture Experts Group (MPEG) II.

According to a first aspect of. the present invention there is provided a variable length decoding apparatus comprising:
memory means for storing variable length coded bit data, shifting N-bit data which is previously output according to a control signal, produced from a control means, by a value of the control signal from the initial bit of the N-bit data, and outputting new N-bit data from a newly initial bit formed due to the shift of the previous N-bit data,
characterised in that;
the control means is for comparing code state values for discriminating a plurality of groups with each other in correspondence to the plurality of the groups for discriminating variable length codes in a variable length code table with each other, with N-bit data which is currently input from the memory means, determining a group corresponding to the currently output N-bit data, and outputting a control signal for representing the number of bits of the bit data used for the determination of the group according to the determination result, a select signal for representing the determined group and N-bit data just preceding the current N-bit data,
and in that the apparatus also includes;
combination logic means including a plurality of input combinations of which the values are determined by current N-bit data output from the control means and previous N-bit data output from the memory means individually corresponding to the plurality of the groups, and generating a plurality of symbols individually corresponding to the respective group according to values of the individual input combinations; and
a multiplexer for receiving the plurality of the symbols generated by the logic combination means and outputting symbols selected by a select signal of the control means.

Preferably, said N-bit data length is determined by a pattern of the bit data possessed by variable length codes constituting the variable length code table.

Said N-bit data is preferably 4-bit data.

Preferably, said groups are identified with each other on the basis of the most significant bits having the identical values to each other.

Said variable length code table is preferably a table for transformation coefficients obtained by a discrete cosine transform method.

Said memory means preferably comprises:
a circular queue memory including a reading window having an N-bit data size, for outputting the N-bit data in the reading window region of which the position is designated by the reading pointer among the stored data to said control means and said combinational logic means; and
an input and output controller for altering a value of the reading pointer according to the control signal generated by said control means.

Said circular queue memory preferably further comprises a register for storing the variable length coded data and outputs the N-bit data whenever a data request signal is applied thereto, and wherein said circular queue memory is divided into a plurality of sections each of which storage region has N-bit data size, generates said data request signal whenever the section designated by said reading pointer value is altered into another section, and stores the N-bit data supplied from said register in response to said data request signal.

Preferably said control means generates the control signal comprising code length information representing the number of significant bits used for determining the group among the currently input N-bit data and first information representing whether a sign bit is contained in the currently input N-bit data, when the specific group corresponding to the currently input N-bit data is determined by the determination result.

Said control signal preferably represents the number of bits determined by said code length information and said first information.

Preferably, said control means generates the control signal comprising second information representing that the specific group is not determined on the basis of the currently input N-bit data, when the specific group corresponding to the currently input N-bit data is not determined by the determination result.

Said second information preferably represents the number (N) of bits of the N-bit data.

Preferably said combinational logic means comprises a plurality of combinational logic circuits for outputting run data and run level corresponding to corresponding input combinational values on the basis of the minimum bit values which can identify the variable length codes belonging to the respective groups with each other.

According to a second aspect of the present invention, there is provided a variable length decoding method comprising the steps of:
(a) establishing code state values for discriminating a plurality of groups with each other in correspondence to the plurality of the groups for discriminating variable length codes in a variable length code table with each other;
(b) establishing a plurality of input combinations of which the values are determined by current N-bit data and previous N-bit data individually corresponding to the plurality of the groups, and a plurality of symbols individually corresponding to values of the individual input combinations;
(c) storing variable length coded bit data and outputting N-bit data from a newly first bit by shifting the first bit of the previously output N-bit data by a value of control signal;
(d) determining a group corresponding to the current N-bit data on the basis of the comparison of the code state value established by step (a) with the current N-bit data output by step (c), and outputting a control signal for representing the number of bits of the bit data used for the determination of the group according to the determination result, a select signal for representing the determined group and N-bit data just preceding the current N-bit data; and
(e) determining symbols according to the N-bit data output from step (c) and the N-bit data output from step (d) on the basis of the plurality of symbols corresponding to the values of the plurality of the input combinations and the individual input combinations.

Said step (a) preferably comprises the step of dividing the variable length codes into the plurality of groups on the basis of the most significant bits having the identical values to each other.

Said N-bit data length is preferably determined by a pattern of the bit data possessed by variable length codes constituting the variable length code table.

Said N-bit data is preferably 4-bit data.

Preferably, said step (b) further comprises the step of storing the minimum bit values capable of identifying the variable length codes belonging to the respective groups with each other, and symbols corresponding to the respective minimum bit values.

Said step (d) may comprise the step (d1) of generating the control signal comprising code length information representing the number of significant bits used for determining the group among the currently input N-bit data and first information representing whether a sign bit is contained in the currently input N-bit data, when the specific group corresponding to the currently input N-bit data is determined by the determination result.

Said step (d1) may further comprise the step of determining a value of the control signal by adding the code length information value and the first information value.

Said step (d) may comprise the step (d2) of generating the control signal comprising second information representing that the specific group is not determined on the basis of the currently input N-bit data, when the specific group corresponding to the currently input N-bit data is not determined by the determination result.

Said step (d2) may further comprise the step of generating the second information having the number (N) of the bits of the N-bit data as the control signal.

Preferably, said step (e) comprises the steps of:
(e1)generating a plurality of symbols individually corresponding to the respective groups according to the N-bit data output from said step (c) and the individual values of the plurality of the input combinations based on the N-bit data output from said step (d); and
(e2)selecting one of the plurality of the symbols generated in step (e1) as a symbol of the variable length decoding operation.

For a better understanding of the invention, and to show how embodiments of the same may be carried into effect, reference will now be made, by way of example, to the accompanying diagrammatic drawings, in which:
Figure 1 is a block diagram of a conventional variable length decoder for decoding variable-length-coded data;
Figure 2 is a block diagram of a variable length decoder according to a preferred embodiment of the present invention; and
Figures 3A through 3C show variable length code tables rearranged for a discrete cosine transform coefficients proposed by the MPEG II in different forms.

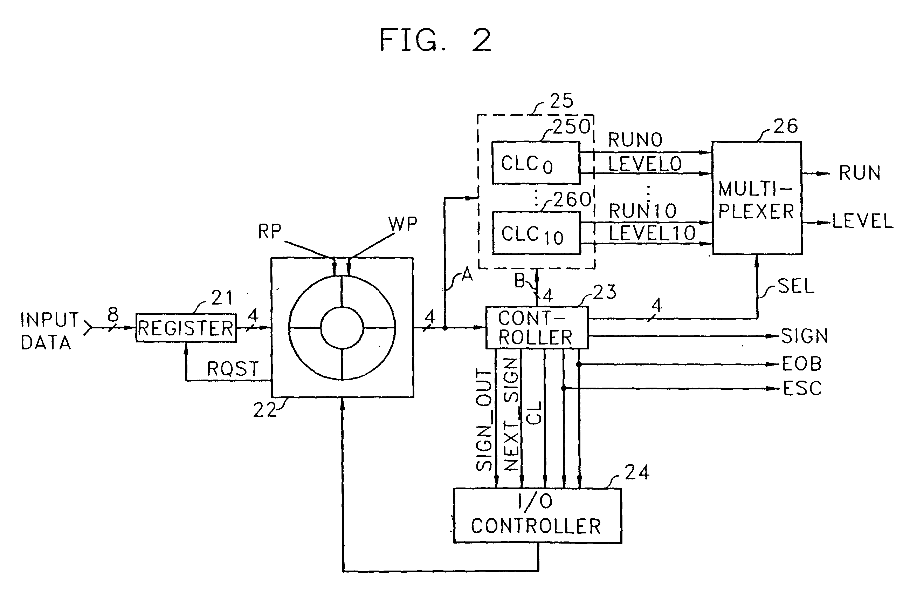

A preferred embodiment of the present invention will be described below in more detail with reference to the accompanying drawings Figures 2 through 3C.

The present invention provides a system for variable-length-decoding input data based on characteristics of variable length code tables.

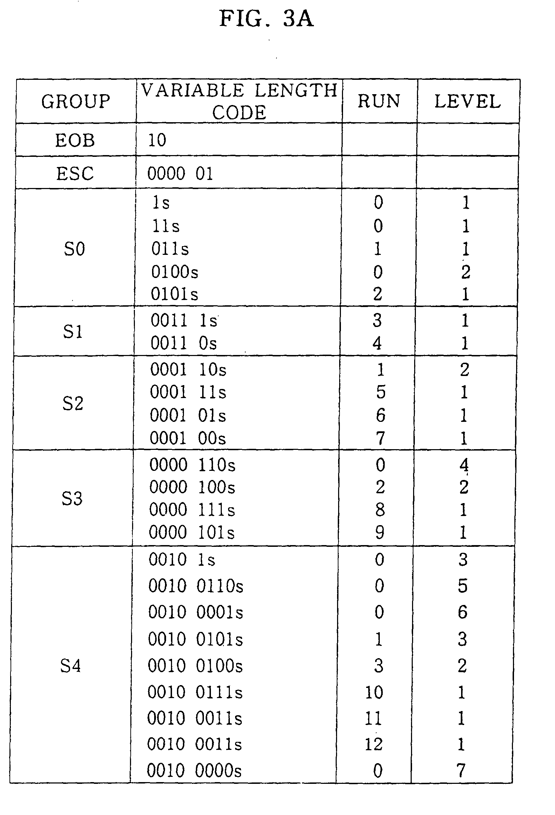

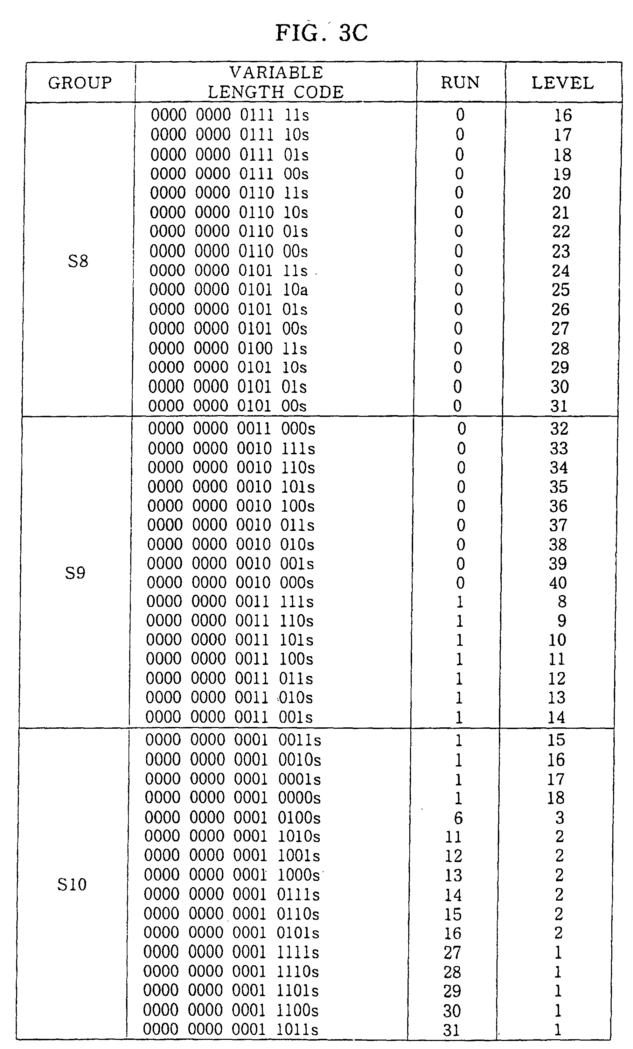

Prior to describing the variable length decoding system proposed, the characteristics of the variable length code tables will be described below with reference to Figures 3A through 3C. The tables shown in Figures 3A through 3C are for variable-length-coding the DCT coefficients. The DCT coefficients are generated by a discrete cosine transform method which is a kind of orthogonal transform coding method, which are generated by orthogonal transform of pixel values contained within a video block composed of NxN pixels. A variable length code table proposed by the MPEG II in connection with the DCT coefficients is composed of [run, level] symbols and variable length codes assigned to the respective [run, level] symbols as shown in Figures 3A through 3C. The variable length code tables shown in Figures 3A through 3C are rearranged in sequence different from those of the variable length code tables proposed by the MPEG II. In other words, the variable length code tables shown in Figures 3A through 3C are rearranged so that the variable length codes having the same values in a plurality of the most significant bits (MSB) among the variable length codes form the same group. The rearranged variable length codes are divided into thirteen groups as shown in Figures 3A through 3C. Each group is discriminated by values (EOB, ESC AND S₀ through S₁₀) of the groups. In Figures 3A through 3C "s" located in the end of each variable length code represents a sign bit of level. If the value of s is "1," the level is positive and if the value of s is "0" the level is negative.

Figure 2 shows an apparatus for variable-length-decoding input data on the basis of rearranged variable length code tables shown in Figures 3A through 3C. The Figure 2 apparatus includes a register 21 for receiving 8-bit parallel data and outputting 4-bit parallel data. The 8-bit parallel data input to register 21 is obtained by converting variable length coded data bitstream into parallel data. Such data conversion is accomplished by a serial-to-parallel conversion type first-in-first-out (FIFO) memory (not shown). A circular queue memory 22 for storing the 4-bit parallel data output from register 21 includes four sections each of which has a 4-bit sized storage region. Thus, circular queue memory 22 can store 16-bit data at the same time. Such a circular queue memory 22 generates a data request signal RQST in order to receive 4-bit parallel data from register 21. Circular queue memory 22 stores the 4-bit parallel data output from register 21 in positions of the recording window designated by a write pointer (wp). Circular queue memory 22 outputs 4-bit data A₃A₂A₁A₀ in the window designated by a read pointer (RP) among the stored bit data. The recording window and the reading window have a 4-bit size which has a start position designated by the WP and RP, respectively. The output data A₃A₂A₁A₀ of circular queue memory 22 is applied to a controller 23 and a combinational logic portion 25, respectively. Controller 23 generates signals SIGN, SIGN_OUT, NEXT_SIGN, CL, EOB, ESC or SEL on the basis of input data A₃A₂A₁A₀. The signals SIGN, SIGN_OUT, NEXT SIGN, CL, EOB, ESC or SEL are supplied to an input and output (I/O) controller 24. Select signal SEL is supplied to a multiplexer 26. Sign signal SIGN, EOB code and ESC code are supplied to a quantizer (not shown) in the succeeding end. Controller 23 also outputs 4-bit data B₃B₂B₁B₀ which has been received just in advance of currently input data A₃A₂A₁A₀ from circular queue memory 22 to combinational logic portion 25. Combinational logic portion 25 includes eleven combinational logic circuits 250, 251, ..., and 260 corresponding to groups S₁-S₁₀. The combinational logic circuits 250 through 260 are represented as abbreviation CLC which are identified with each other by subscripts in Figure 2. The respective combinational circuits 250 through 260 combine data A₃A₂A₁A₀ applied from circular queue memory 22 with data B₃B₂B₁B₀ applied from controller 23, according to an input combinational logic described in Table 2, to then output [run, level] data corresponding to the combined bit data. Multiplexer 26 outputs [run,level] data selected by select signal SEL from controller 23 among eleven [run, level] data supplied from combination logic portion 25. I/O controller 24 which is located between controller 23 and circular queue memory 22 controls data storage and output in or from circular queue memory 22. I/O controller 24 determines values of the RP and WP according to signals SIGN OUT, NEXT_SIGN, CL, EOB and ESC supplied from controller 23. I/O controller 24 determines values of the RP and WP, so that a start position of the recording window designated by the WP always leads to that of the reading window designated by the RP by one section. I/O controller 24 also determines a value of the WP so that the reading window is always shifted by one section interval. The value of the WP is changed by four, every time the start position of the reading window is shifted by the RP to the following section. The value-determined RP and WP are applied to circular queue memory 22.

The operation of the Figure 2 apparatus having the above construction will be described below.

Register 21 outputs in parallel the firstly input 4-bit data to circular queue memory 22 whenever data request signal RQST is applied from circular queue memory 22. Circular queue memory 22 stores 4-bit data supplied from register 21 in the recording window having the start position designated by the current WP. Circular queue memory 22 generates a new data request signal RQST and applies the generated RQST to register 21 when the RP-designated section is altered. When the RP is applied from I/O controller 24, circular queue memory 22 outputs 4-bit data in the reading window having the start position designated by the current RP value among the stored data to controller 23. Controller 23 determines whether the 4-bit data A₃A₂A₁A₀ applied from circular queue memory 22 belongs to which one of groups EOB, ESC and S₀-S₁₀, on the basis of the following Table 1. Controller 23 generates signals SIGN, SIGN_OUT, NEXT_SIGN, CL, EOB, ESC or SEL according to the determination result of the group. In Table 1, character "X" and bit values in the parentheses represent that a bit value of the place "0" or "1" is a "don't care place" for determining a group to which 4-bit data belongs. The number of the significant bits used for determining the group among the currently input 4-bit data is represented as a code length signal (CL).

In groups EOB, S₀-S₂ and S₄, the CL is the number of the bits in a first code state excluding the character "X" and the number of the bits in the parentheses. For example, in case of the group EOB, the CL becomes "2" which is the number of bits "10" in "10XX". In groups ESC, S₃ S₅ and S₆, the CL is the number of the bits in a second code state excluding the character "X". In groups S₇-S₁₀, the CL is the number of the bits in a third code state excluding the character "X". The sign output signal SIGN OUT has a value of "1" when a sign bit "s" is contained in the currently input 4-bit data A₃A₂A₁A₀ while if not, the former has a value of "0". A next sign signal NEXT_SIGN to be described later represents that a group is not determined with respect to the currently input data. A sign signal SIGN represents a sign bit of a level. The EOB and ESC codes have been described referring to Figure 1.

| Group | 1st Code State | 2nd Code State | 3rd Code State |
|---|---|---|---|
| EOB | 10XX | | |
| ESC | 0000 | 01XX | |
| S₀ | 1XXX | | |
| | 11XX | | |
| | 01 (1X) | | |
| | 01(0X) | | |
| S₁ | 0011 | | |
| S₂ | 0001 | | |
| S₃ | 0000 | 1XXX | |
| S₄ | 0010 | (1XXX) | |
| | 0010 | (0XXX) | |
| S₅ | 0000 | 001X | |
| S₆ | 0000 | 0001 | |
| S₇ | 0000 | 0000 | 1XXX |
| S₈ | 0000 | 0000 | 01XX |
| S₉ | 0000 | 0000 | 001X |
| S₁₀ | 0000 | 0000 | 0001 |

The operations of controller 23, I/O controller 24 and circular queue memory 22 will be described in more detail with reference to Table 1, and Figures 3A through 3C.

Controller 23 performs a group determination operation with respect to the currently input 4-bit data A₃A₂A₁A₀. If the currently input 4-bit data A₃A₂A₁A₀ is determined as a specific group, controller 23 generates the EOB, ESC, SIGN OUT, NEXT_SIGM, or CL on the basis of the determined group and corresponding code state of the group. Controller 23 outputs select signal SEL representing the determined group to multiplexer 26. Controller 23 also outputs 4-bit data B₃B₂B₁B₀ just preceding the 4-bit data A₃A₂A₁A₀ used for determining the current group to combinational logic portion 25. In case of the groups EOB, S₀-S₂, and S₄, a corresponding group can be determined by only currently input 4-bit data irrespective of the previously input data. A case that the currently input 4-bit data A₃A₂A₁A₀ is determined as a group S₀ will be described below. When the first code state value is "1XXX", "11XX" or "01(1X)" in Table 1, controller 23 generates sign signal SIGN, sign output signal SIGN_OUT having a value of "1," code length signal (CL) representing the number of significant bits used for the group determination, that is, "1" or "2." Controller also generates select signal SEL representing that group S₀ has been determined by the currently input 4-bit data A₃A₂A₁A₀. Such a select signal is composed of 4-bit data so that groups S₀-S₁₀ can be identified with each other. When the first code state value is "01(0X)", controller 23 generates select signal SEL, code length signal CL representing "2" being the number of the significant bits and next sign signal NEXT_SIGN. As can be seen in Figure 3A, this is because when the first code state value is "01 (0x)", the sign bit "s" is not contained in the currently input 4-bit data A₃A₂A₁A₀. When it is determined that the EOB code is contained in the currently input 4-bit data A₃A₂A₁A₀, controller 23 supplies the detected EOB code to I/O controller 24 and succeeding quantizer (not shown). Since the EOB code does not have sign bit "s", controller 23 generates sign output signal SIGN_OUT having a value of "0". When a specific group corresponding to the currently input 4-bit data A₃A₂A₁A₀ is not determined, for example, when the currently input 4-bit data A₃A₂A₁A₀ has the first code state value corresponding to groups Esc, S₃ and S₅-S₁₀, controller 23 stores the first code state value and generates the next sign signal NEXT SIGN. In this case, since the specific group has not been determined, the CL and SEL are not generated. Also, the 4-bit data input from circular queue memory 22 is not supplied to combinational logic portion 25. In the above description, the operation of the controller 23 is not described with respect to the other groups which are determined by the first code state value. However, a person skilled in the art will understand well the operation of controller 23 with respect to the other groups on the basis of the above description.

I/O controller 24 determines values of the WP and RP on the basis of the EOB, ESC, NEXT_SIGN, SIGN_OUT, or CL supplied from controller 23. When the SIGN_OUT signal is applied together with the CL signal, I/O controller 24 adds the SIGN_OUT signal and the CL signal and determines a value of the RP. Thus, when sign bit "s" is contained in the currently input 4-bit data A₃A₂A₁A₀ output from circular queue memory 22, the sign bit is excluded from the 4-bit data to be succeedingly output from circular queue memory 22. When the NEXT_SIGN signal is applied together with the CL signal, I/O controller 24 shifts a value of the RP by "4" and shifts a value of the WP by "4" as well. Thus, the positions of the reading and recording windows designated by the RP and WP are shifted to the following sections by one section respectively. For example, when the currently input 4-bit data A₃A₂A₁A₀ in controller 23 has the first code state value of "0000" in group S₃, 4-bit data to be succeedingly output from circular queue memory 22 becomes "1XXX." If the start position in the reading window is shifted to the following section, circular queue memory 22 generates the RQST signal and register 21 supplies the 4-bit data to circular queue memory 22 in response to the RQST signal. Circular queue memory 22 stores the input 4-bit data in the position designated by the recording window.

When the 4-bit data in the reading window of which the position is newly designated by the RP is supplied to controller 23, controller 23 judges whether the 4-bit data A₃A₂A₁A₀ applied from circular queue memory 22 belongs to which one of groups EOB, ESC, and S₁-S₁₀. When a specific group is not determined by the 4-bit data A₃A₂A₁A₀ in the just previous group determination, controller 23 judges whether the newly applied 4-bit data belongs to which one of groups ESC, S₃, and S₅-₁₀. If the newly applied 4-bit data is determined as one of groups ESC, S₃, and S₅-S₁₀ by the group determination, controller 23 generates the CL, SIGN_OUT, NEXT_SIGN or SEL on the basis of the determined group and the second code state value of Table 1 with respect to the group. Also, controller 23 outputs the 4-bit data input in advance of the 4-bit data used for the group determination to combinational logic portion 25. Determination of the specific group based on the 8-bit is the same as that using only 4-bit data except that the code states used for determination of the CL differ from each other. Accordingly, the detailed description thereof will be omitted. When the specific group is not determined by the 8-bit data, controller 23 determines a specific symbol on the basis of the 12-bit data. That is, controller 23 stores the first and second code state values which are determined on the basis of the previous 4-bit data or the 8-bit data and determines a corresponding group on the basis of the stored first and second code state values and the newly applied 4-bit data. The processes of determining the group based on the 12-bit input data can be understood well with reference to a case that the group is determined with only 4-bit data. In the above description, when the group is not determined on the basis of the currently input 4-bit data, controller 23 stores the corresponding first state value. Since the first and second code state values are identical to each other when the group is not determined as can be seen from Table 1, another embodiment in which the NEXT_SIGN signal is stored instead is possible.

Combinational logic portion 25 which receives the 4-bit data A₃A₂A₁A₀ output from circular queue memory 22 and the 4-bit data B₃B₂B₁B₀ output from controller 23 is composed of eleven combination logic circuits 250 through 260 having input combinational logic states represented in the following Table 2.

**Table 2**

| COMBINATIAL LOGIC | INPUT COMBINATIAL STATES |
|---|---|
| CLC₀ | A₃A₂A₁A₀ |
| CLC₁ | A₃ |
| CLC₂ | A₃A₂ |
| CLC₃ | A₂A₁ |
| CLC₄ | A₃A₂A₁A₀ |
| CLC₅ | B₀A₃A₂ |
| CLC₆ | A₃A₂A₁A₀ |
| CLC₇ | B₂B₁B₀A₃ |
| CLC₈ | B₁B₀A₃A₂ |
| CLC₉ | B₀A₃A₂A₁ |
| CLC₁₀ | A₃A₂A₁A₀ |

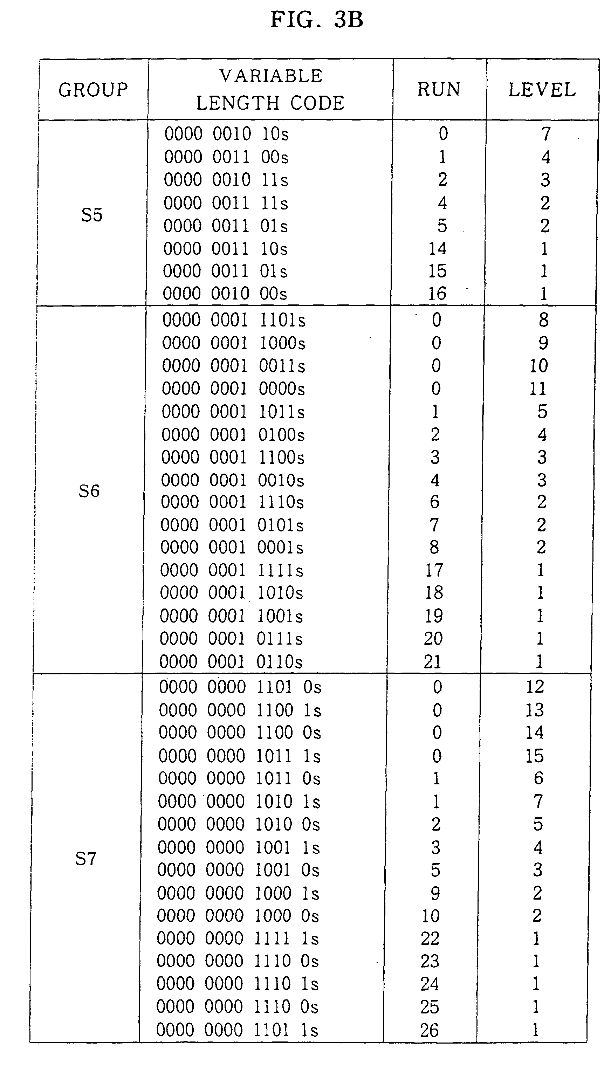

Combinational logic circuit 250 stores combinational logic CLC₀ in Table 2, and the other combinational logic circuits 251 through 260 also store the corresponding combinational logics CLC₁ through CLC₁₀. The combinational logics CLC₀ through CLC₁₀ stored in combinational circuit 250 through 260 correspond to groups S₀ through S₁₀, respectively. That is, combinational logic circuit 250 stores variable length codes belonging to group S₀ and [run, level] data corresponding to the variable length codes. The other combinational logic circuits 251 through 260 store variable length codes belonging to the corresponding groups and [run, level] data corresponding to the variable length codes, respectively. Actually, combinational logic circuits 250 through 260 do not store all bit values of the corresponding variable length codes and store only predetermined code identification bits existing in the front end of the sign bit "s" so that the variable length codes in the same group are identified with each other instead. For example, combinational logic circuit 251 stores part of the variable length codes belonging to group S₁ of Figure 3A, that is, "1" or "0". Combinational logic circuit 253 stores bit information "01," "00," "11" and "01". If the 4-bit data A₃A₂A₁A₀ from circular queue memory 22 and the 4-bit data B₃B₂B₁B₀ from controller 23 are applied to combinational logic portion 25, combinational logic circuits 250 through 260 combine the input bit data according to the corresponding input combinational states represented in Table 2. Here, the 4-bit data B₃B₂B₁B₀ input from controller 23 is data output from circular queue memory 22, earlier than the 4-bit data A₃A₂A₁A₀ which is currently input from circular queue memory 22. For example, combinational logic circuit 250 outputs [run, level] data which is determined by input data "A₃A₂A₁A₀". If A₃A₂A₁A₀ equals "011X," combinational logic circuit 250 outputs corresponding [run, level] data as [1, 1] as in Figure 3A. Combinational logic circuit 255 outputs [run, level] data determined by input data B₀A₃A₂." Thus, when B₀A₃A₂ equals "110," [run, level] data is output as [14, 1] as in Figure 3B. The [run, level] data determined by the respective combinational logic circuits 250 through 260 are output to multiplexer 26, multiplexer 26 outputs [run, level] data corresponding to select signal SEL applied from controller 23 among eleven pairs of the [run, level] data applied from the combination logic circuits. The [run, level] data output from multiplexer 26 is used for an inverse quantizer (now shown).

As described above, the variable length decoding method and apparatus uses the ROM comprising a barrel shifter and a variable length decoding table, and has simpler hardware construction in comparison to an existing apparatus which decodes variable length coded data into a [run, level] symbol, thereby giving an effect of maintaining a required processing speed.

## Claims

1. A variable length decoding apparatus comprising:
memory means (22)for storing variable length coded bit data, shifting N-bit data which is previously output according to a control signal, produced from a control means (23), by a value of the control signal from the initial bit of the N-bit data and outputting new N-bit data from a newly initial bit formed due to the shift of the previous N-bit data,
**characterised in that**;
the control means (23) is for comparing code state values for discriminating a plurality of groups with each other in correspondence to the plurality of the groups for discriminating variable length codes in a variable length code table with each other, with N-bit data which is currently input from said memory means, determining a group corresponding to the currently output N-bit data, and outputting a control signal for representing the number of bits of the bit data used for the determination of the group according to the determination result, a select signal for representing the determined group and N-bit data just preceding the current N-bit data,
and **in that** the apparatus also includes;
combination logic means (25) including a plurality of input combinations which individually correspond to the plurality of the groups, and of which the values are determined by current N-bit data output from said control means (23) and previous N-bit data output from said memory means (22), for generating a plurality of symbols individually corresponding to each group according to values of the individual input combinations; and
a multiplexer (26) for receiving a plurality of the symbols generated by said logic combination means (25) and outputting symbols selected by a select signal.

2. The variable length decoding apparatus according to claim 1, wherein said N-bit data length is determined by a pattern of the bit data possessed by variable length codes constituting the variable length code table.

3. The variable length decoding apparatus according to claim 1 or 2, wherein said N-bit data is 4-bit data.

4. The variable length decoding apparatus according to any of the preceding claims wherein said groups are identified with each other on the basis of the most significant bits having the identical values to each other.

5. The variable length decoding apparatus according to any of the preceding claims wherein said variable length code table is a table for transformation coefficients obtained by a discrete cosine transform method.

6. The variable length decoding apparatus according to any of the preceding claims wherein said memory means (22) comprises:
a circular queue memory including a reading window having an N-bit data size, for outputting the N-bit data in the reading window region of which the position is designated by the reading pointer among the stored data to said control means and said combinational logic means; and
an input and output controller (24) for altering a value of the reading pointer according to the control signal generated by said control means.

7. The variable length decoding apparatus according to claim 6, wherein said circular queue memory further comprises a register (21) for storing the variable length coded data and outputs the N-bit data whenever a data request signal is applied thereto, and wherein said circular queue memory is divided into a plurality of sections each of which storage region has N-bit data size, generates said data request signal whenever the section designated by said reading pointer value is altered into another section, and stores the N-bit data supplied from said register (21) in response to said data request signal.

8. The variable length decoding apparatus according to any of the preceding claims wherein said control means (23) generates the control signal comprising code length information representing the number of significant bits used for determining the group among the currently input N-bit data and first information representing whether a sign bit is contained in the currently input N-bit data, when the specific group corresponding to the currently input N-bit data is determined by the determination result.

9. The variable length decoding apparatus according to claim 8, wherein said control signal represents the number of bits determined by said code length information and said first information.

10. The variable length decoding apparatus according to any of the preceding claims , wherein said control means (23) generates the control signal comprising second information representing that the specific group is not determined on the basis of the currently input N-bit data, when the specific group corresponding to the currently input N-bit data is not determined by the determination result.

11. The variable length decoding apparatus according to claim 10, wherein said second information represents the number (N) of bits of the N-bit data.

12. The variable length decoding apparatus according to any of the preceding claims, wherein said combinational logic means (25) comprises a plurality of combinational logic circuits (250-260) for outputting run data and run level corresponding to corresponding input combinational values on the basis of the minimum bit values which can identify the variable length codes belonging to the respective groups with each other.

13. A variable length decoding method comprising the steps of:
(a) establishing code state values for discriminating a plurality of groups with each other in correspondence to the plurality of the groups for discriminating variable length codes in a variable length code table with each other;
(b) establishing a plurality of input combinations of which the values are determined by current N-bit data and previous N-bit data individually corresponding to the plurality of the groups, and a plurality of symbols individually corresponding to values of the individual input combinations;
(c) storing variable length coded bit data and outputting N-bit data from a newly first bit by shifting the first bit of the previously output N-bit data by a value of a control signal;
(d) determining a group corresponding to the current N-bit data on the basis of the comparison of the code state value established by step (a) with the current N-bit data output by step (c), and outputting a control signal for representing the number of bits of the bit data used for the determination of the group according to the determination result, a select signal for representing the determined group and N-bit data just preceding the current N-bit data; and
(e) determining symbols according to the N-bit data output from step (c) and the N-bit data output from step (d) on the basis of the plurality of symbols corresponding to the values of the plurality of the input combinations and the individual input combinations.

14. The variable length decoding method according to claim 13, wherein said step (a) comprises the step of dividing the variable length codes into the plurality of groups on the basis of the most significant bits having the identical values to each other.

15. The variable length decoding method according to claim 13 or 14, wherein said N-bit data length is determined by a pattern of the bit data possessed by variable length codes constituting the variable length code table.

16. The variable length decoding method according to claim 15, wherein said N-bit data is 4-bit data.

17. The variable length decoding method according to any of claims 13 to 16 wherein said step (b) further comprises the step of storing the minimum bit values capable of identifying the variable length codes belonging to the respective groups with each other, and symbols corresponding to the respective minimum bit values.

18. The variable length decoding method according to any of claims 13 to 17 wherein said step (d) comprises the step (d1) of generating the control signal comprising code length information representing the number of significant bits used for determining the group among the currently input N-bit data and first information representing whether a sign bit is contained in the currently input N-bit data, when the specific group corresponding to the currently input N-bit data is determined by the determination result.

19. The variable length decoding method according to claim 18, wherein said step (d1) further comprises the step of determining a value of the control signal by adding the code length information value and the first information value.

20. The variable length decoding method according to claim 13, wherein said step (d) comprises the step (d2) of generating the control signal comprising second information representing that the specific group is not determined on the basis of the currently input N-bit data, when the specific group corresponding to the currently input N-bit data is not determined by the determination result.

21. The variable length decoding method according to claim 20, wherein said step (d2) further comprises the step of generating the second information having the number (N) of the bits of the N-bit data as the control signal.

22. The variable length decoding method according to any of claims 13 to 21, wherein said step (e) comprises the steps of:
(e1)generating a plurality of symbols individually corresponding to the respective groups according to the N-bit data output from said step (c) and the individual values of the plurality of the input combinations based on the N-bit data output from said step (d); and
(e2) selecting one of the plurality of the symbols generated in step (e1) as a symbol of the variable length decoding operation.

## Patentansprüche

1. Vorrichtung zur Dekodierung mit variablen Längen die Folgendes umfasst:
Speichereinrichtung (22) zur Abspeicherung von Bit-Daten, die mit variablen Längen kodiert sind, zur Verschiebung von N-Bit-Daten, die vorhergehend entsprechend einem Kontrollsignal ausgegeben wurden, das von einer Kontrollvorrichtung (23), anhand eines Wertes des Kontrollsignals, aus dem Anfangsbit der N-Bit-Daten erzeugt wird und die neuen N-Bit-Daten, gebildet aus einem neuen Anfangsbit, das aufgrund der Verschiebung der vorhergehenden n-Bit-Daten erstellt wurde, ausgibt,
und **dadurch gekennzeichnet ist, dass**
Kontrollvorrichtung (23) zum Vergleich von Code-Zustandswerten dient, zur Unterscheidung einer Vielzahl von Gruppen voneinander, in Übereinstimmung mit der Vielzahl von Gruppen zur Unterscheidung von Codes mit variablen Längen voneinander in einer Codetabelle für variable Längen, mit N-Bit-Daten als aktuelle Eingabe aus der Speichereinrichtung (22), die eine Gruppe entsprechend der laufenden N-Bit-Datenausgabe festlegen und zur Ausgabe eines Kontrollsignals, das die Anzahl von Bits der Bit-Daten darstellt, die, entsprechend dem Ergebnis der Festlegung, zur Festlegung der Gruppe benutzt wird, mit einem Select-Signal zur Darstellung der festgelegten Gruppe und der N-Bit-Daten, die den aktuellen N-Bit-Daten gerade vorausgingen,
und dass die Vorrichtung Folgendes einschließt;
Vorrichtung zur logischen Verknüpfung (25), die eine Vielzahl von Eingabekombinationen einschließt, welche der Vielzahl von Gruppen entspricht und deren Werte durch aktuelle N-Bit-Daten festgelegt werden, die von der Kontrollvorrichtung (23) ausgegeben werden und durch die vorausgehenden N-Bit-Daten aus der Speichervorrichtung (22), um eine Vielzahl von Symbolen zu erzeugen, welche individuell mit jeder Gruppe, entsprechend den Werten der individuellen Eingabekombinationen korrespondieren; und
Multiplexer (26) zum Empfang einer Vielzahl von Symbolen, die von der Vorrichtung zur logischen Verknüpfung erzeugt werden und zur Ausgabe der Symbole, die von einem Select-Signal ausgewählt werden.

2. Vorrichtung zur Dekodierung mit variablen Längen entsprechend Anspruch 1, bei der die Länge der N-Bit-Daten von einem Muster der Bit-Daten bestimmt wird, das von Codes mit variabler Länge eingenommen wird, welche die Code-Tabelle mit variablen Längen bilden.

3. Vorrichtung zur Dekodierung mit variablen Längen entsprechend Anspruch 1 oder 2, bei der die N-Bit-Daten 4-Bit-Daten sind.

4. Vorrichtung zur Dekodierung mit variablen Längen entsprechend allen vorgehenden Ansprüchen, bei der die Gruppen untereinander auf der Basis der signifikantesten Bits gekennzeichnet sind, die dieselben Werte zueinander besitzen.

5. Vorrichtung zur Dekodierung mit variablen Längen entsprechend allen vorgehenden Ansprüchen, bei welcher die Code-Tabelle mit variablen Längen eine Tabelle mit Koeffizienten ist, die mit dem Verfahren der diskreten Kosinus-Transformation erstellt wird.

6. Vorrichtung zur Dekodierung mit variablen Längen entsprechend allen vorgehenden Ansprüchen, bei der die Speichervorrichtungen (22) Folgendes umfassen:
Umlauf-Wartespeicher (circular queue memory) mit einem Lesefenster (reading window), das eine N-Bit Datengröße zur Ausgabe der N-Bit-Daten in den Bereich des Einlesefensters beinhaltet, dessen Position unter den gespeicherten Daten der Kontrollvorrichtung und der Vorrichtung zur logischen Verknüpfung von dem Lesezeiger (reading pointer) bezeichnet wird; und einen Ein- /Ausgangs-Kontroller zur Umänderung des Wertes des Lesezeigers entsprechend eines Kontrollsignals, das von der Kontrolleinheit erzeugt wird.

7. Vorrichtung zur Dekodierung mit variablen Längen entsprechend Anspruch 6, bei welcher der Umlauf-Wartespeicher des weiteren ein Register (21) zur Speicherung der Code-Daten mit variablen Längen umfasst und die N-Bit-Daten ausgibt, immer wenn ein Datenanforderungssignal (data request signal) sich darauf bezieht und bei welcher der Umlauf-Wartespeicher in eine Vielzahl von Feldem unterteilt ist, wobei jede Speicherregion N-Bit Datengröße besitzt, das Datenanforderungssignal erzeugt, immer wenn der Bereich, welcher durch den Wert des Lesezeigers bezeichnet ist, in einen anderen Bereich wechselt und die N-Bit-Daten aus dem Register (21) als Folge des Datenanforderungssignals abspeichert.

8. Vorrichtung zur Dekodierung mit variablen Längen entsprechend allen vorgehenden Ansprüchen, bei der die Kontrollvorrichtung (23) ein Kontrollsignal erzeugt, das eine Codelängen-Information umfasst, welche die Anzahl der signifikanten Bits darstellt, die zur Bestimmung der Gruppe aus den aktuellen N-Bit-Eingangsdaten genutzt werden und eine erste Information umfasst, die aussagt, ob ein Zeichen-Bit (sign bit) in den aktuellen N-Bit-Daten enthalten ist, für den Fall, dass die spezifische Gruppe, die den aktuellen N-Bit-Eingangsdaten entspricht, durch das Auswahlergebnis ausgewählt wird.

9. Vorrichtung zur Dekodierung mit variablen Längen entsprechend Anspruch 8, bei welcher das Kontrollsignal die Anzahl von Bits darstellt, die durch die Längeninformation und die erste Information festgelegt werden.

10. Vorrichtung zur Dekodierung mit variablen Längen entsprechend allen vorgehenden Ansprüchen, bei der die Kontrollvorrichtung (23) ein Kontrollsignal erzeugt, das eine zweite Information umfasst, die aussagt, dass die spezifische Gruppe auf der Basis der aktuellen N-Bit-Eingangsdaten nicht ausgewählt wird, für den Fall, dass die spezifische Gruppe, die den aktuellen N-Bit-Eingangsdaten entspricht, durch das Auswahlergebnis nicht ausgewählt wird.

11. Vorrichtung zur Dekodierung mit variablen Längen entsprechend Anspruch 10, bei der die zweite Information die Anzahl (N) der Bits der N-Bit-Daten darstellt.

12. Vorrichtung zur Dekodierung mit variablen Längen entsprechend allen vorgehenden Ansprüchen, bei der die Einrichtung zur logischen Verknüpfung eine Vielzahl von logischen Verknüpfungsschaltungen (250-260) zur Ausgabe von Run-Daten und Run-Level umfasst, die den entsprechenden kombinatorischen Eingangswerten auf der Basis der geringsten Bit-Werte entsprechen, welche die Codes mit variablen Längen, die zu den jeweiligen Gruppen gehören, voneinander unterscheiden können.

13. Verfahren zur Dekodierung mit variablen Längen, das folgende Schritte umfasst:
(a) Eine Festlegung von Code-Zustandswerten zur Unterscheidung einer Vielzahl von Gruppen voneinander in Übereinstimmung mit der Vielzahl von Gruppen zur Unterscheidung der Codes mit variablen Längen in einer Codetabelle mit variablen Längen voneinander;
(b) eine Festlegung von einer Vielzahl von Eingangsverknüpfungen deren Werte von den aktuellen und den vorausgehenden N-Bit-Daten bestimmt sind, die individuell der Vielzahl von Gruppen entsprechen und eine Festlegung einer Vielzahl von Symbolen, die individuell den Werten der individuellen Eingangsverknüpfungen entsprechen.
(c) Speicherung der Bit-Daten, die mit variablen Längen codiert wurden und Ausgabe von N-Bit-Daten anhand eines neuen ersten Bits durch Verschiebung des ersten Bits der vorausgegangenen Ausgangs-N-Bit-Daten aufgrund des Wertes eines Kontrollsignals;
(d) Bestimmung einer Gruppe entsprechend den aktuellen N-Bit-Daten auf der Basis des Vergleichs des Code-Zustandswertes, festgelegt durch Schritt (a), mit der aktuellen N-Bit-Datenausgabe, festgelegt durch Schritt (c), und Ausgabe eines Kontrollsignals zur Darstellung der Zahl der Bits der Bit-Daten, die zur Bestimmung der Gruppe entsprechend des Bestimmungsergebnisses verwendet werden, sowie eines Select-Signals zur Darstellung der ausgewählten Gruppe und der N-Bit-Daten, die den aktuellen N-Bit-Daten gerade vorausgegangen sind; und
(e) Bestimmungssymbole entsprechend den Ausgangs-N-Bit-Daten aus Schritt (c) und den Ausgangs-N-Bit-Daten von Schritt (d) auf der Basis der Vielzahl von Symbolen, die den Werten einer Vielzahl von Eingangskombinationen und den individuellen Eingangskombinationen entsprechen.

14. Verfahren zur Dekodierung mit variablen Längen entsprechend Anspruch 13, bei dem der Schritt (a) einen Schritt umfasst, bei dem die Codes mit variablen Lägen auf eine Vielfalt von Gruppen auf der Basis der signifikantesten Bits, welche untereinander die gleichen Werte besitzen, aufgeteilt werden.

15. Verfahren zur Dekodierung mit variablen Längen entsprechend Anspruch 13 oder 14, bei dem die Länge der N-Bit-Daten durch ein Muster von Bit-Daten bestimmt wird, die von Codes mit variablen Längen eingenommen werden, welche die Tabelle des Codes mit variablen Längen bilden.

16. Verfahren zur Dekodierung mit variablen Längen entsprechend Anspruch 15, bei dem die N-Bit-Daten 4-Bit-Daten sind.

17. Verfahren zur Dekodierung mit variablen Längen entsprechend allen Ansprüchen 13 bis 16, bei dem der Schritt (b) des weiteren den Schritt der Speicherung der minimalen Bit-Werte umfasst, welche die Codes mit variablen Längen identifizieren können, die zu den jeweiligen Gruppen gehören, und der Symbole umfasst, die den jeweiligen minimalen Bit-Werten entsprechen.

18. Verfahren zur Dekodierung mit variablen Längen entsprechend allen Ansprüchen 13 bis 17, bei dem der Schritt (d) den Schritt (d1) der Erzeugung eines Kontrollsignals umfasst, welches eine Codelängen-Information umfasst, die die Anzahl der signifikanten Bits darstellt, welche zur Bestimmung der Gruppe unter den aktuellen N-Bit-Daten benutzt wird und eine erste Information, die festlegt ob ein Zeichen-Bit in den aktuellen Eingangs-N-Bit-Daten enthalten ist, *wenn* die spezifische Gruppe entsprechend den aktuellen Eingangs-N-Bit-Daten durch das Bestimmungsergebnis ausgewählt wurde.

19. Verfahren zur Dekodierung mit variablen Längen entsprechend Anspruch 18, bei dem der Schritt (d1) des weiteren den Schritt der Bestimmung eines Wertes des Kontrollsignals durch Addition des Wertes der Codelängen-Infomation und des Wertes der ersten Information, umfasst.

20. Verfahren zur Dekodierung mit variablen Längen entsprechend Anspruch 13, bei dem der Schritt (d) den Schritt (d2) zur Erzeugung des Kontrollsignals umfasst, welches die zweite Information umfasst, die darstellt, dass die spezifische Gruppe auf der Basis der aktuellen N-Bit-Daten nicht ausgewählt wurde, *wenn* die spezifische Gruppe entsprechend den aktuellen Eingangs-N-Bit-Daten durch das Bestimmungsergebnis nicht ausgewählt wurde.

21. Verfahren zur Dekodierung mit variablen Längen entsprechend Anspruch 13, bei dem der Schritt (d2) den Schritt zur Erzeugung der zweiten Information als Kontrollsignal mit der Bitanzahl (N) der N-Bit-Daten umfasst.

22. Verfahren zur Dekodierung mit variablen Längen entsprechend allen Ansprüchen 13 bis 21, bei dem der Schritt (e) folgende Schritte umfasst:
(e1) Erzeugung einer Vielzahl von Gruppen, die den jeweiligen Gruppen, in Übereinstimmung mit der N-Bit-Datenausgabe aus Schritt (c) entsprechen und die Erzeugung der individuellen Werte aus der Vielzahl von Eingabekombinationen auf der Basis der N-Bit-Datenausgabe aus dem Schritt (d); und
(e2) Auswahl eines Symbols aus der Vielzahl von Symbolen, die in Schritt (e1) erzeugt wurden als Symbol der Operation der Dekodierung mit variablen Längen.

## Revendications

1. Dispositif de décodage à longueur variable comprenant:
des moyens de mémoire (29) pour la mémorisation de données de bits codés selon un codage à longueur variable, décaler les données à N bits, qui sont délivrées précédemment en fonction d'un signal de commande, produit à partir de moyens de commande (23), et ce d'une valeur du signal de commande par rapport au bit initial des données à N bits et délivrer de nouvelles données à N bits à partir d'un nouveau bit initial sous l'effet du décalage des données précédentes à N bits,
**caractérisé en ce que**
les moyens de commande (23) servent à comparer les valeurs d'état de code pour discriminer une pluralité de groupes entre eux d'une manière correspondant à la pluralité des groupes, afin de discriminer des codes à longueur variable les uns des autres dans une table de codes à longueur variable à des données à N bits, qui sont introduites simultanément à partir desdits moyens de mémoire, déterminer un groupe correspondant aux données à N bits actuellement délivrées et délivrer un signal de commande servant à représenter le nombre de bits des données de bits utilisées pour la détermination du groupe conformément au résultat de la détermination, un signal de sélection pour représenter le groupe déterminé, et des données à N bits qui précèdent directement les données à N bits actuelles, et
**en ce que** le dispositif comporte également:
des moyens logiques de combinaison (25) incluant une pluralité de combinaisons d'entrée, qui correspondent individuellement à la pluralité des groupes et dont les valeurs sont déterminées par des données à N bits actuelles délivrées par lesdits moyens de commande (23) et par des données à N bits précédentes délivrées par lesdits moyens de mémoire (22) pour produire une pluralité de symboles correspondant individuellement à chaque groupe en fonction de valeurs des combinaisons individuelles d'entrée; et
un multiplexeur (26) pour recevoir une pluralité des symboles produits par lesdits moyens logiques de combinaison (25) et délivrer des symboles sélectionnés par un signal de sélection.

2. Dispositif de décodage à longueur variable selon la revendication 1, dans lequel ladite longueur des données à N bits est déterminée par une configuration des données de bits, que possèdent des codes à longueur variable constituant la table de codes à longueur variable.

3. Dispositif de décodage à longueur variable selon la revendication 1 ou 2, dans lequel lesdites données à N bits sont des données à 4 bits.

4. Dispositif de décodage à longueur variable selon l'une quelconque des revendications précédentes, dans lequel lesdits groupes sont identifiés entre eux sur la base de deux bits de poids les plus significatifs possédant les mêmes valeurs entre eux.

5. Dispositif de décodage à longueur variable selon l'une quelconque des revendications précédentes, dans lequel ladite table de codes à longueur variable est une table pour des coefficients de transformation obtenus au moyen d'un procédé de transformation en cosinus discret.

6. Dispositif de décodage à longueur variable selon l'une quelconque des revendications précédentes, dans lequel lesdits moyens de mémoire (22) comprennent:
une mémoire à file d'attente circulaire incluant une fenêtre de lecture possédant une taille de données à N bits, pour délivrer les données à N bits dans la région de la fenêtre de lecture, dont la position est désignée par le pointeur de lecture parmi les données mémorisées, pour lesdits moyens de commande et lesdits moyens logiques de combinaison; et
un contrôleur d'entrée et de sortie (24) pour modifier une valeur du pointeur de lecture en fonction du signal de commande produit par lesdits moyens de commande.

7. Dispositif de décodage à longueur variable selon la revendication 6, dans lequel ladite mémoire à file d'attente circulaire comporte en outre un registre (21) pour mémoriser les données codées à longueur variable et délivrer les données à N bits chaque fois qu'un signal de demande de données est appliqué, et dans lequel ladite mémoire à file d'attente circulaire est divisée en une pluralité de sections, chaque région de mémoire comportant une taille de données à N bits, produit le signal de demande de données chaque fois que la section désignée par la valeur dudit pointeur de lecture est modifiée dans une autre section et mémorise les données à N bits délivrées par ledit registre (21) en réponse audit signal de demande de données.

8. Dispositif de décodage à longueur variable selon l'une quelconque des revendications précédentes, dans lequel lesdits moyens de commande (23) produisent le signal de commande comprenant l'information de longueur de code représentant le nombre de bits significatifs utilisés pour déterminer le groupe parmi les données à N bits actuellement introduites et une première information indiquant si un bit de signe est contenu dans les données à N bits actuellement introduites, lorsque le groupe spécifique correspondant aux données à N bits actuellement introduites est déterminé par le résultat de la détermination.

9. Dispositif de décodage à longueur variable selon la revendication 8, dans lequel ledit signal de commande représente le nombre de bits déterminé par ladite information de longueur de code et ladite première information.

10. Dispositif de décodage à longueur variable selon l'une quelconque des revendications précédentes, dans lequel lesdits moyens de commande (23) produisent le signal de commande comprenant une seconde information indiquant que le groupe spécifique n'est pas déterminé sur la base des données à N bits actuellement introduites lorsque le groupe spécifique correspondant aux données à N bits actuellement introduites n'est pas déterminé par le résultat de la détermination.

11. Dispositif de décodage à longueur variable selon la revendication 10, dans lequel ladite seconde information représente le nombre (N) de bits des données à N bits.

12. Dispositif de décodage à longueur variable selon l'une quelconque des revendications précédentes, dans lequel lesdits moyens logiques de combinaison (25) comprennent une pluralité de circuits logiques de combinaison (250-260) servant à délivrer des données d'exécution et un niveau d'exécution correspondant à des valeurs correspondantes de combinaison d'entrée sur la base des valeurs de bits minimales qui peuvent identifier les uns par rapport aux autres les codes à longueur variable faisant partie des groupes respectifs.

13. Procédé de décodage à longueur variable comprenant les étapes consistant à:
(a) établir des valeurs d'état de code pour établir une discrimination entre une pluralité de groupes en fonction de la pluralité des groupes pour discriminer les uns des autres des codes à longueur variable dans une table de codes à longueur variable;
(b) établir une pluralité de combinaisons d'entrée dont les valeurs sont déterminées par les données à N bits actuelles et des données à N bits précédentes, qui correspondent individuellement à la pluralité des groupes, et une pluralité de symboles correspondant individuellement à des valeurs des combinaisons d'entrée individuelles;
(c) mémoriser des données de bits codés selon le codage à longueur variable et délivrer des données à N bits à partir d'un nouveau premier bit par décalage du premier bit des données à N bits de sortie délivrées précédemment, et ce d'une valeur d'un signal de commande;
(d) déterminer un groupe correspondant aux données à N bits actuelles sur la base de la comparaison de la valeur d'état de code établie par l'étape (a) avec les données de sortie avec les données à N bits actuelles délivrées lors de l'étape (c) et délivrer un signal de commande pour représenter le nombre de bits des données de bits utilisées pour la détermination du groupe conformément au résultat de détermination, un signal de sélection pour représenter le groupe déterminé et des données à N bits qui précèdent directement les données à N bits actuelles; et
(e) déterminer des symboles conformément aux données à N bits délivrées à partir de l'étape (c) et les données à N bits délivrées à partir de l'étape (d) sur la base de la pluralité de symboles correspondant aux valeurs de la pluralité des combinaisons d'entrée et des combinaisons d'entrée individuelles.

14. Procédé de décodage à longueur variable selon la revendication 13, selon lequel ladite étape (a) comprend l'étape de division des codes à longueur variable en la pluralité de groupes sur la base des bits de plus les plus significatifs possédant des valeurs identiques entre elles.

15. Procédé de décodage à longueur variable selon la revendication 13 ou 14, selon lequel ladite longueur de données à N bits est déterminée par un réseau de données de bits, que possèdent des codes à longueur variable constituant la table de codes à longueur variable.

16. Procédé de décodage à longueur variable selon la revendication 15, dans lequel lesdites données à N bits sont des données à 4 bits.

17. Procédé de décodage à longueur variable selon l'une quelconque des revendications 13 à 16, selon lequel ladite étape (b) comprend en outre l'étape de mémorisation des valeurs de bits minimales qui peuvent identifier les uns par rapport aux autres les codes à longueur variable faisant partie des groupes respectifs, et de symboles correspondant aux valeurs de bits minimales.

18. Procédé de décodage à longueur variable selon l'une quelconque des revendications 13 à 17, selon lequel ladite étape (d) comprend l'étape (d1) de production du signal de commande comprenant une information de longueur de code représentant le nombre de bits significatifs utilisés pour déterminer le groupe parmi les données à N bits actuellement introduites et une première information indiquant si un bit de signe est contenu dans les données à N bits actuellement introduites, lorsque le groupe spécifique correspondant aux données à N bits introduites actuellement est déterminé par le résultat de détermination.

19. Procédé de décodage à longueur variable selon la revendication 18, selon lequel ladite étape (d) comprend en outre l'étape de détermination d'une valeur du signal de commande par addition de la valeur d'information de longueur de code et de la première valeur d'information.

20. Procédé de décodage à longueur variable selon la revendication 13, dans lequel ladite étape (d) comprend l'étape (d2) de production du signal de commande comprenant une seconde information indiquant que le groupe spécifique n'est pas déterminé sur la base des données à N bits actuellement introduites, lorsque le groupe spécifique correspond aux données à N bits introduites actuellement n'est pas déterminé par le résultat de détermination.

21. Procédé de décodage à longueur variable selon la revendication 20, selon lequel ladite étape (d2) comprend en outre l'étape consistant à produire la seconde information possédant le nombre (N) des bits des données à N bits en tant que signal de commande.

22. Procédé de décodage à longueur variable selon l'une quelconque des revendications 13 à 21, selon lequel ladite étape (e) comprend les étapes consistant à:
(e1) produire une pluralité de symboles correspondant individuellement aux groupes respectifs conformément aux données à N bits délivrées par ladite étape (c) et les valeurs individuelles de la pluralité de combinaisons d'entrée basées sur les données à N bits délivrés par ladite étape (e); et
(e2) sélectionner l'un de la pluralité des symboles produits lors de l'étape (e1) en tant que symboles de l'opération de décodage à longueur variable.
